# EUROPÄISCHE PATENTANMELDUNG

(11) **EP 1 542 325 A1**
(43) Veröffentlichungstag der Anmeldung: **15.06.2005**
(21) Anmeldenummer: 04012007.3
(22) Anmeldetag: 21.05.2004
(51) Int. Cl.: H02B 1/28

(54) **Schaltschrank**

(30) Priorität: 12.12.2003 DE 20319311 U; 27.04.2004 DE 202004006679 U
(71) Anmelder: Pfannenberg GmbH, 21035 Hamburg (DE)
(72) Erfinder: Pfannenberg, Andreas, 21035 Hamburg (DE)
(74) Vertreter: Richter, Werdermann, Gerbaulet & Hofmann

(57) **Zusammenfassung**

Zur Vermeidung einer Verformung eines Druck- und/oder Sogkräften ausgesetzten, insbesondere in Tunnelbereichen und/oder in Verbindungsstollen von Tunnelröhren, insbesondere für Schienenfahrzeuge, aufgestellten Schaltschrankes (10) und seiner Wände und zur Erhöhung seiner Standfestigkeit bei Einwirkung von Druck- und/oder Saugkräften ist der Schaltschrank (10) mit Einrichtungen (100) für einen vom Außendruck bzw. von Sogkräften abhängigen Druckausgleich im Innenraum des Schaltschrankes versehen.

## Beschreibung

Die Erfindung betrifft einen Druck- und Sogkräften ausgesetzten Schaltschrank gemäß dem Oberbegriff des Anspruches 1.

Die in, insbesondere von Eisenbahnfahrzeugen befahrenen Tunnelröhren oder in Verbindungsstollen zweier Tunnelröhren aufgestellten Schaltschränke ohne oder mit Kühl- und/oder Heiztechnik sind durch die fahrenden Züge starken Druck- und/oder Sogbelastungen ausgesetzt, die zu einer Verformung, insbesondere der Seitenwände des Schaltschrankes führen, so dass aufwendige Verstärkungen im Bereich der Seitenwände eingebaut werden müssen, was mit zusätzlichen Kosten verbunden ist. Hinzukommt, dass die starken auf den Schaltschrank einwirkenden Druckund/oder Sogkräfte trotz umfassender Verankerung des Schaltschrankes an seinem Untergrund, der Schaltschrank von seinem Untergrund, wenn auch nur geringfügig, abgehoben wird, was sich ungünstig auf die elektronischen Bauelemente im Innenraum des Schaltschrankes auswirken kann.

Es ist daher Aufgabe der vorliegenden Erfindung, einen Schaltschrank gemäß der eingangs beschriebenen Art so auszubilden, dass er unter Vermeidung der oben genannten Nachteile starken Druck- und/oder Sogkräften ausgesetzt werden kann, ohne dass die elektronischen Bauteile im Innenraum des Schaltschrankes irgendwelchen Beschädigungen ausgesetzt werden, wobei der Schaltschrank überall dort eingesetzt werden soll, wo Druckschwankungen und Sogwirkungen zu kompensieren sind.

Gelöst wird diese Aufgabe bei einem Schaltschrank mit den im Anspruch 1 gekennzeichneten Merkmalen.

Hiernach besteht die Erfindung darin, dass zur Vermeidung einer Verformung des Schaltschrankes und seiner Wände und zur Erhöhung seiner Standfestigkeit bei Einwirkung von Druck- und/oder Saugkräften der Schaltschrank mit Einrichtungen für einen vom Außendruck bzw. von Sogkräften abhängigen Druckausgleich im Innenraum des Schaltschrankes versehen ist.

Eine Ausführungsform der Erfindung sieht vor, dass als Einrichtung für einen vom Außendruck bzw. von Sogkräften abhängigen Druckausgleich im Innenraum des Schaltschrankes eine im Innenraum des Schaltschrankes angeordnete, den Innenraum in mindestens zwei Kammern unterteilende Membranwand vorgesehen ist, wobei eine der beiden Kammern mit der Umgebungsluft in Verbindung steht und die jeweils andere Kammer die elektronischen Bauteile aufnimmt, wobei die Membranwand Druckund Saugkräfte aufnimmt zur Schaffung gleicher Druckverhältnisse auf den Innenseiten und Außenseiten des Schaltschrankes durch einen Druckaufbau im Innenraum des Schaltschrankes zur Schaffung eines Druckausgleiches.

Eine weitere Ausführungsform der Erfindung sieht vor, dass als Einrichtung für einen vom Außendruck bzw. von Sogkräften abhängigen Druckausgleich im Innenraum des Schaltschrankes mindestens eine Wand des Schaltschrankes oder Teilbereiche der Schaltschrankwand bzw. -wände ausgebildet ist.

Eine Ausführungsform der Erfindung besteht darin, dass als Einrichtung für einen vom Außendruck bzw. von Sogkräften abhängigen Druckausgleich im Innenraum des Schaltschrankes der Innenraum des Schaltschrankes in mindestens zwei durch eine Trennwand getrennte Kammern unterteilt ist, von denen die erste Kammer die elektronischen Bauteile aufnimmt und der Innenraum der anderen Kammer über eine Durchbrechung in der die Kammer begrenzenden Seitenwand mit der Außenluft verbunden ist, wobei die Trennwand als Membran ausgebildet ist.

Ferner sieht die Erfindung eine Ausführungsform vor, nach der als Einrichtung für einen vom Außendruck bzw. von Sogkräften abhängigen Druckausgleich im Innenraum des Schaltschrankes der Innenraum des Schaltschrankes in drei durch zwei Trennwände getrennte Kammern unterteilt ist, von denen die mittlere Kammer die elektronischen Bauteile aufnimmt und von denen die jeweils außenliegende Kammer oder beide außenliegenden Kammern über eine Durchbrechung oder zwei Durchbrechungen in der die Kammern begrenzenden Außen-Seitenwand mit der Außenluft verbunden ist, wobei die Trennwände als Membran ausgebildet sind.

Nach einer weiteren Ausführungsform sieht die Erfindung vor, dass als Einrichtung für einen vom Außendruck bzw. von Sogkräften abhängigen Druckausgleich im Innenraum des Schaltschrankes der Innenraum des Schaltschrankes in durch eine feststehende, unelastische Trennwand getrennte Kammern unterteilt ist, von denen die eine Kammer die elektronischen Bauteile aufnimmt, und der Innenraum der bauteilefreien Kammer über eine in der die Kammer begrenzenden Schaltschrankwand ausgebildeten Durchbrechung mit der Außenluft verbunden ist, wobei in der bauteilfreien Kammer ein vollelastischer Behälter, Schlauch oder Sack angeordnet ist, der mit einem gasförmigen Medium, wie Luft, gefüllt ist und der in allen Richtungen Druckwellen kompensierbar ist.

Die Erfindung beinhaltet eine Ausführungsform, die darin besteht, dass als Einrichtung für einen vom Außendruck bzw. von Sogkräften abhängigen Druckausgleich im Innenraum des Schaltschrankes der Schaltschrank mit einem gehäuseartigen Dachmodul versehen ist, das auf den Schaltschrank aufgesetzt ist und dessen Innenraum mindestens eine den Innenraum in zwei Kammern unterteilende Membranwand aufweist, wobei die eine Kammer mit der Umgebungsluft und die andere Kammer mit dem Innenraum des Schaltschrankes in Verbindung steht.

Eine Ausführungsform der Erfindung besteht darin, dass als Einrichtung für einen vom Außendruck bzw. von Sogkräften abhängigen Druckausgleich im Innenraum des Schaltschrankes der Schaltschrank mit mindestens einem in den Innenraum des Schaltschrankes einschiebbaren, gehäuseartigen Einschubmodul versehen ist, dessen Innenraum mindestens eine den Innenraum in zwei Kammern unterteilende Membranwand aufweist, wobei die eine Kammer mit der Umgebungsluft und die andere Kammer mit dem Innenraum des Schaltschrankes in Verbindung steht.

Die Erfindung umfasst auch eine Ausführungsform, die darin besteht, dass als Einrichtung für einen vom Außendruck bzw. von Sogkräften abhängigen Druckausgleich im Innenraum des Schaltschrankes der Schaltschrank mit mindestens einem gehäuseartigen Wandmodul versehen ist, das an eine Schaltschrankwand befestigt ist und dessen Innenraum mindestens eine den Innenraum in zwei Kammern unterteilende Membranwand aufweist, wobei die eine Kammer mit der Umgebungsluft und die andere Kammer mit dem Innenraum des Schaltschrankes in Verbindung steht.

Eine Ausführungsform der Erfindung besteht darin, dass als Einrichtung für einen vom Außendruck bzw. von Sogkräften abhängigen Druckausgleich im Innenraum des Schaltschrankes der Schaltschrank mit mindestens einem gehäuseartigen Wandmodul versehen ist, das an der Tür des Schaltschrankes befestigt ist, und dessen Innenraum mindestens eine den Innenraum in zwei Kammern unterteilende Membranwand aufweist, wobei die eine Kammer mit der Umgebungsluft und die andere Kammer mit dem Innenraum des Schaltschrankes in Verbindung steht.

Als Einrichtung für einen vom Außendruck bzw. von Sogkräften abhängigen Druckausgleich im Innenraum des Schaltschrankes sieht die Erfindung auch eine Ausführungsform vor, die darin besteht, dass in dem Innenraum des Schaltschrankes ein Kolbenelement oder Faltenbelagelement angeordnet ist, wobei das Kolbenelement aus einem Gehäuse mit einem in diesem geführten das Gehäuse in zwei Kammern unterteilenden Kolben besteht, wobei die eine Kammer mit der Umgebungsluft und die andere Kammer mit dem Innenraum des Schaltschrankes in Verbindung steht.

Der mit den erfindungsgemäßen Ausgestaltungen erzielte Vorteil besteht darin, dass Schaltschränke auftretende Druck- und Sogkräfte aufnehmen bzw. ausgleichen können, ohne dass es hinsichtlich der konstruktiven Ausgestaltung der Schaltschränke besonderer technischer Maßnahmen bedarf. Die Schaltschränke bedürfen keiner zusätzlich verstärkenden Konstruktionen; weder die Schaltschrankwände noch die Verankerung der Schaltschränke müssen verstärkt werden. Druckkräfte werden von der Membran aufgenommen und nicht auf die Schaltschrankkonstruktion weitergeleitet, so dass der Schaltschrank selbst von den einwirkenden Kräften entlastet wird. Aufgrund der erfindungsgemäßen Ausgestaltung können derartige Schaltschränke besonders in Tunnelröhren und Verbindungsstollen von zwei parallel geführten Tunnelröhren, in denen insbesondere auch Hochgeschwindigkeitszüge fahren, aufgestellt werden. Vermittels in den Schaltschränken angeordneten bzw. ausgebildeten Einrichtungen werden Druckverhältnisse auf der Innenseite und der Außenseite des Schrankes ausgeglichen. Im Innenraum des Schaltschrankes wird ein Gegendruck zum einwirkenden Außendruck aufgebaut, was durch eine Volumenänderung im Innenraum des Schaltschrankes erreicht wird.

Weitere vorteilhafte Ausgestaltungen sind Gegenstand der Unteransprüche.

Ausführungsbeispiele der Erfindung sind in der Zeichnung dargestellt. Es zeigt:
- Fig. 1: eine schematische Darstellung zweier über einen Verbindungsstollen miteinander verbundenen Tunnelröhren für Schienenfahrzeuge, wobei in dem Verbindungsstollen ein Schaltschrank angeordnet ist,
- Fig. 2: eine schaubildliche Ansicht eines Schaltschrankes mit einer als Membran ausgebildeten Wand,
- Fig. 3: einen senkrechten Schnitt gemäß Linie III-III in Fig. 2,
- Fig. 4: eine schaubildliche Ansicht einer weiteren Ausführungsform eines zwei Kammern aufweisenden Schaltschrankes,
- Fig. 5: einen senkrechten Schnitt gemäß Linie IV-IV in Fig. 5,
- Fig. 6: eine schematische Darstellung eines Schaltschrankes mit in dessen Innenraum angeordneter Membranwand in Normalstellung und in druckbelasteter Stellung,
- Fig. 7: einen senkrechten Schnitt eines Schaltschrankes mit drei in dessen Innenraum ausgebildeten Kammern, deren beiden Trennwände als Membran ausgebildet sind,
- Fig. 8: teils in Ansicht teils einen senkrechten Schnitt eines Schaltschrankes mit zwei in dessen Innenraum ausgebildeten Kammern, die vermittels einer feststehenden unelastischen Trennwand voneinander getrennt sind, wobei in der bauteilfreien mit der Umgebungsluft in Verbindung stehende Kammer ein Luftpolster angeordnet ist,
- Fig. 9: einen Schaltschrank, teils in Ansicht, teils in einem senkrechten Schnitt mit einem in dem Innenraum des Schaltschrankes angeordneten Einschubmodul, das mit einer Einrichtung für einen Druckausgleich auf der Innenseite und der Außenseite des Schaltschrankes versehen ist,
- Fig. 10: einen Schaltschrank, teils in Ansicht, teils in einem senkrechten Schnitt mit einem auf dem Schaltschrank aufgesetzten Dachmodul, das mit einer Einrichtung für einen Druckausgleich auf der Innenseite und der Außenseite des Schaltschrankes versehen ist,
- Fig. 11: einen Schaltschrank, teils in Ansicht, teils in einem senkrechten Schnitt mit einem an der Schaltschrankwand angeordneten Wandmodul, das mit einer Einrichtung für einen Druckausgleich auf der Innenseite und der Außenseite des Schaltschrankes versehen ist,
- Fig. 12: einen Schaltschrank, teils in Ansicht, teils in einem senkrechten Schnitt mit einem an der Schaltschranktür angeordneten Wandmodul, das mit einer Einrichtung für einen Druckausgleich auf der Innenseite und der Außenseite des Schaltschrankes versehen ist und
- Fig. 13: einen Schaltschrank, teils in Ansicht, teils in einem senkrechten Schnitt mit einer Einrichtung für einen Druckausgleich auf der Innenseite und der Außenseite des Schaltschrankes, die als Kolbenelement ausgebildet ist.

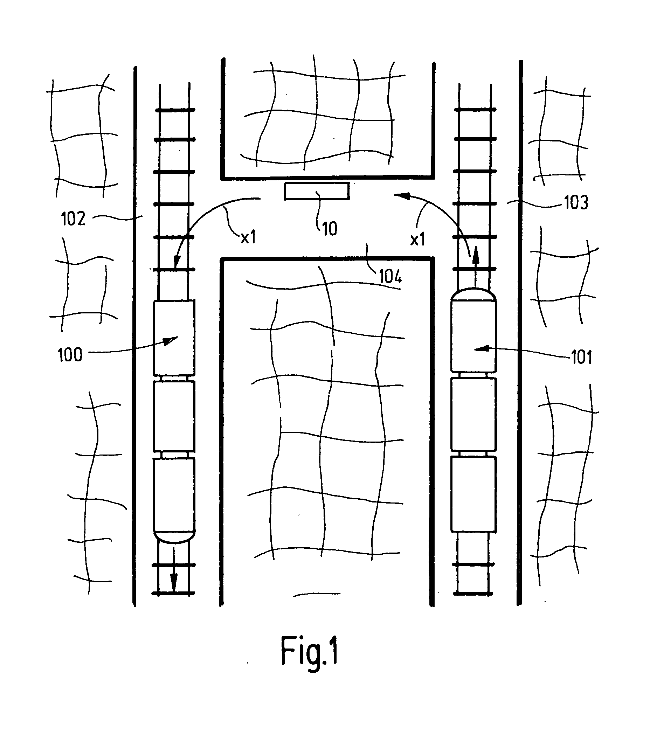

Fig. 1 zeigt ein Tunnelsystem für Schienenfahrzeuge 100, 101 aus zwei parallel geführten Tunnelröhren 102, 103, die über einen Verbindungsstollen 104 miteinander verbunden sind. In dem Verbindungsstollen 104 ist ein Schaltschrank 10 aufgestellt, der in seinem Innenraum 11 die elektronischen Bauteile 30 für die Steuerung von Lüftungssystemen u. dgl. aufnimmt. Durch die durch die Tunnelröhren fahrenden Fahrzeuge werden Druck- und/oder Sogkräfte erzeugt, die auf den Schaltschrank 10 einwirken. Durch das durch die Tunnelröhre 103 fahrende Schienenfahrzeug 101 wird eine Druckwelle erzeugt, die u. a. auch in Pfeilrichtung X auf den Schaltschrank 10 auftrifft. Das in der anderen Richtung in der Tunnelröhre 102 fahrende Schienenfahrzeug 100 erzeugt Sogkräfte, die in Pfeilrichtung X1 auf den Schaltschrank 10 einwirken. Der Schaltschrank 10 ist somit ständig Druck- und/oder Sogkräften ausgesetzt.

Um diese auftretenden Druck- und Sogkräfte unter Beibehaltung einer hohen Standfestigkeit des Schaltschrankes 10 aufnehmen zu können, ist der Schaltschrank 10 mit Einrichtungen 100 für einen Druckausgleich auf der Innenseite und der Außenseite des Schaltschrankes 10 versehen.

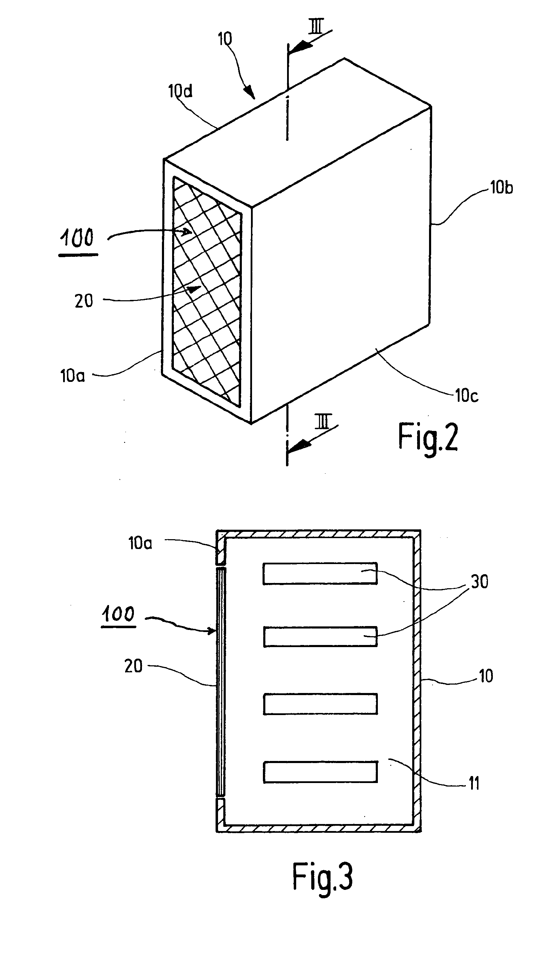

Ein Schaltschrank 10 mit einer Einrichtung 100, die auch gegen Sogkräfte geschützt ist, ist nach Fig. 1 und 2 derart ausgebildet, dass mindestens eine Schaltschrankwand oder Teilbereiche der Schaltschrankwand oder mehrere Schaltschrankwände als Membran ausgebildet ist, so dass ein Druckausgleich möglich ist.

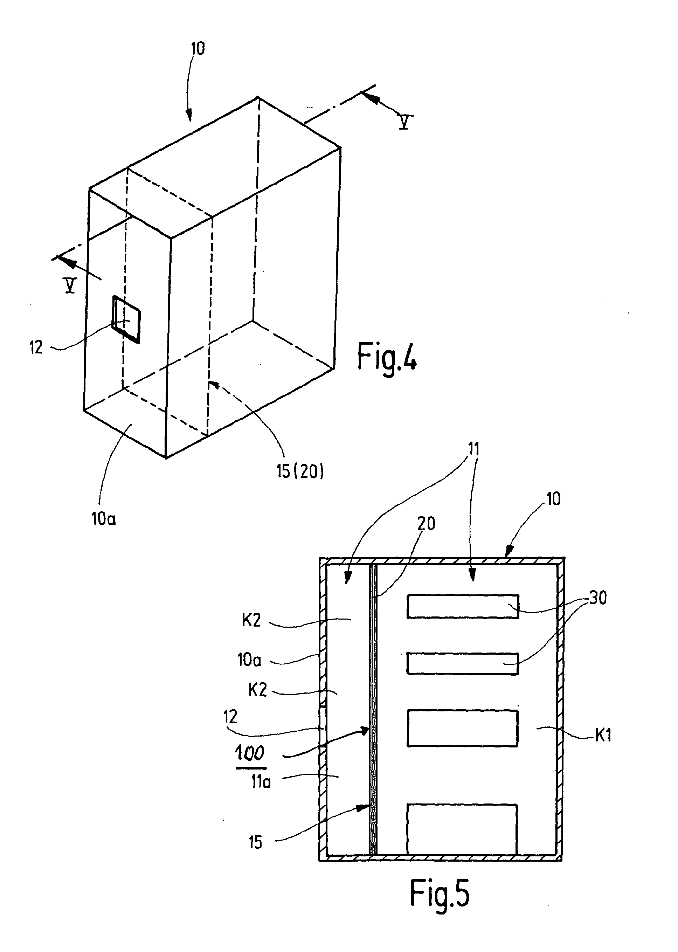

Nach einer weiteren Ausführungsform gemäß Fig. 4 und 5 ist der Innenraum 11 des Schaltschrankes 10 in mindestens zwei durch eine Trennwand 15 getrennte Kammern unterteilt, von denen die erste Kammer K1 die elektronischen Bauteile 30 aufnimmt und der Innenraum der Kammer K2 über eine Durchbrechung 12 in der die zweite Kammer K2 begrenzenden Seitenwand 10a mit der Umgebungsluft verbunden ist, wobei die Trennwand 15 als Membran 20 ausgebildet ist, so dass bei auftretendem Unterdruck und Überdruck über diese Ausgleichsöffnung 12 ein Luftaustausch zum Druckausgleich ermöglicht wird.

Die Membran 20 besteht aus einem gummielastischen oder einem anderen geeigneten Material, das luftundurchlässig ist.

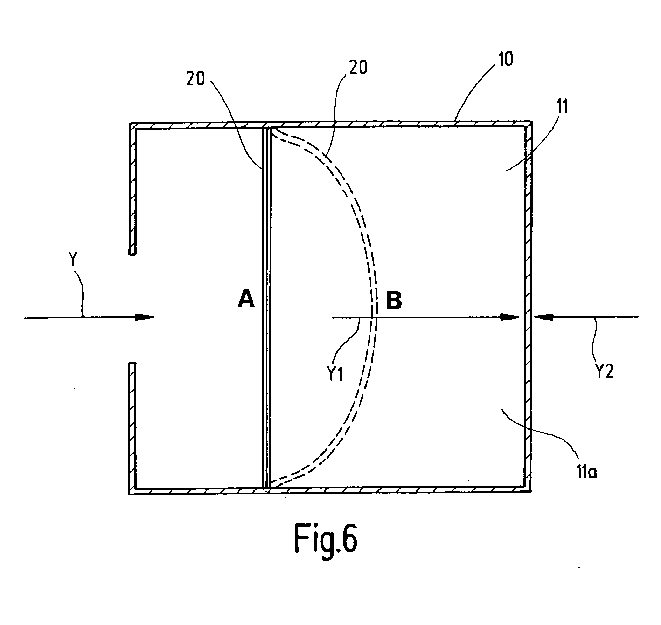

In Fig. 6 ist die Wirkungs- und Arbeitsweise der Membran 20 dargestellt. Die in den Innenraum des Schaltschrankes 10 in Pfeilrichtung Y eindringende Druckwelle trifft auf die die Normalstellung, d. h. druckunbelastete Stellung A, einnehmende Membran 20. Die Druckwelle drückt die Membran 20 in Pfeilrichtung Y1 (Stellung B), die die Luft im Teil 11a des Innenraumes 11 des Schaltschrankes 10 zusammendrückt, so dass in diesem Teil 11a ein Gegendruck gegen den von außen auf die Schaltschrankwand in Pfeilrichtung Y2 einwirkenden Außendruck aufgebaut wird, so dass ein Druckausgleich erfolgt.

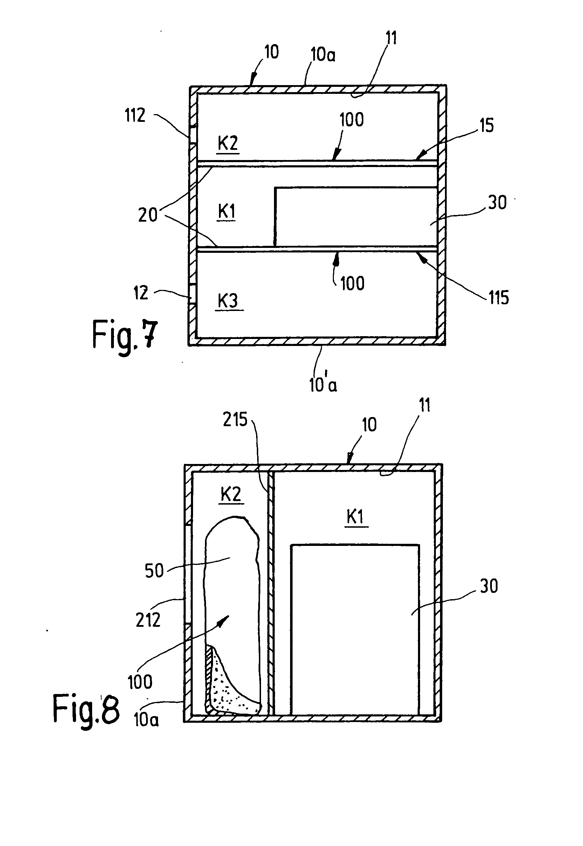

Die Ausführungsform nach Fig. 7 sieht vor, dass als Einrichtung 100 der Innenraum 11 des Schaltschrankes 10 in drei durch zwei Trennwände 15, 115 getrennte Kammern K1, K2, K3 unterteilt ist, von denen die mittlere Kammer K1 die elektronischen Bauteile 30 aufnimmt und von denen die jeweils außenliegende Kammer K2 oder K3 oder beide außenliegenden Kammern K2, K3 über eine Durchbrechung 12 oder zwei Durchbrechungen 12, 112 in der die Kammern K2, K3 begrenzenden Außen-Seitenwand 10a, 10'a mit der Außenluft verbunden ist, wobei die Trennwände 15, 115 als Membrane 20 ausgebildet sind.

Fig. 8 zeigt eine Ausführungsform, nach der als Einrichtung 100 der Innenraum 11 des Schaltschrankes 10 in durch eine feststehende, unelastische Trennwand 215 getrennte Kammern K1, K2 unterteilt ist. Die Kammer K1 nimmt die elektronischen Bauteile 30 auf. Der Innenraum 11 der bauteilefreien Kammer K2 ist über eine in der die Kammer K2 begrenzenden Schaltschrankwand 10a ausgebildeten Durchbrechung 212 mit der Außentuft verbunden. In der bauteilfreien Kammer K2 ist ein vollelastischer Behälter, Schlauch oder Sack 50 angeordnet, der mit einem gasförmigen Medium, wie Luft, gefüllt ist und der in allen Richtungen Druckwellen kompensierbar ist.

Die Durchbrechungen 12, 112, 212 in den Wänden des Schaltschrankes 10, über die die Kammern mit der Umgebungsluft in Verbindung stehen, sind vorteilhafterweise vermittels Gitterplatten verschlossen.

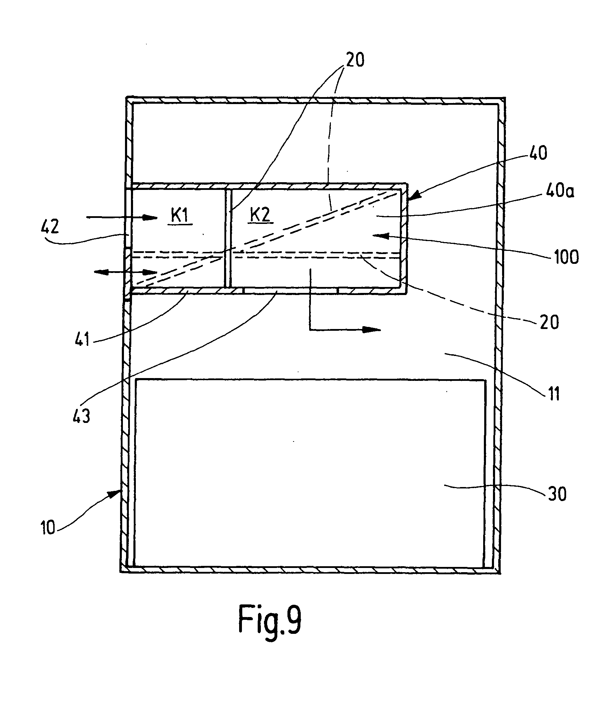

Bei der in Fig. 9 gezeigten Ausführungsform ist der Schaltschrank 10 als Einrichtung 100 mit einem in seinem Innenraum 11 angeordneten Einschubmodul 40 versehen, das vermittels in der Zeichnung nicht dargestellter Führungen einschiebbar und herausziehbar ist und das aus einem Gehäuse 41 besteht, in dessen Innenraum 40a eine den Innenraum in zwei Kammern K1, K2 unterteilende Membranwand 20 angeordnet ist, wobei die Kammer K1 über eine Öffnung 42 in der Gehäusewand mit der Umgebungsluft und die Kammer K2 über eine Öffnung 43 in der Gehäusewand mit dem Innenraum 11 des Schaltschrankes 10 in Verbindung steht. Der Innenraum 11 des Schaltschrankes 10 nimmt die elektronischen Bauteile 30 des Schaltschrankes 10 auf. Die Membranwand 20 kann dabei senkrecht stehend oder waagerecht verlaufend oder diagonal verlaufend in dem Innenraum 40a des Gehäuses 41 des Einschubmoduls 40 angeordnet sein. Es ist jedoch dabei erforderlich, dass der Innenraum 40a des Gehäuses 41 vermittels einer Membranwand 20 in zwei Kammern unterteilt wird, von denen eine Kammer mit der Umgebungsluft und die andere Kammer mit dem Innenraum des Schaltschrankes in Verbindung steht.

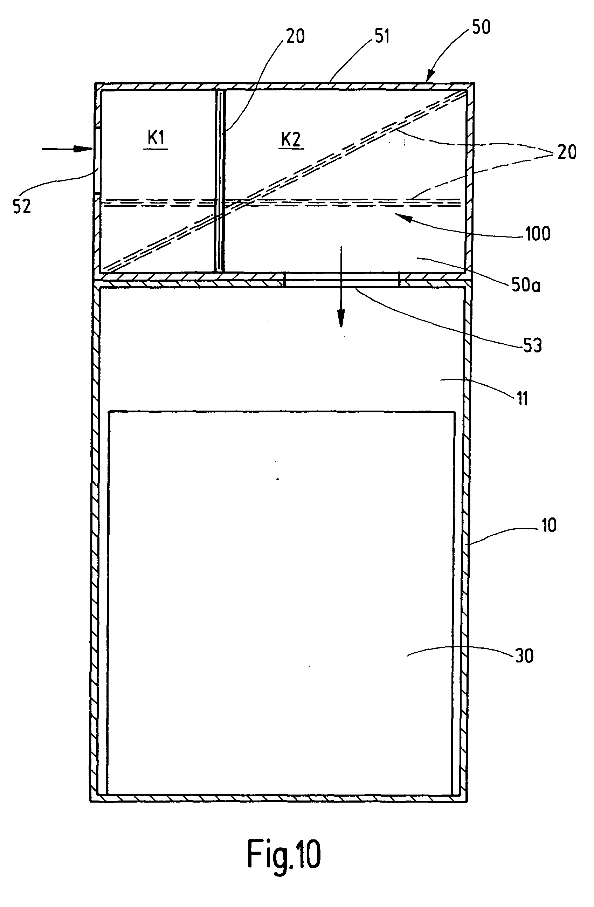

Gemäß Fig. 10 ist auf den Schaltschrank 10 ein Dachmodul 50 angeordnet, das die Einrichtung 100 bildet. Das Dachmodul 50 besteht aus einem Gehäuse 51, in dessen Innenraum 50a eine den Innenraum 50a in zwei Kammern K1, K2 unterteilende Membranwand 20 angeordnet ist, wobei die Kammer K1 über eine Öffnung 52 in der Gehäusewand mit der Umgebungsluft und die Kammer K2 über eine Öffnung 53 in der Gehäusewand und der Schaltschrankwand 10 in Verbindung steht. Der Innenraum 11 des Schaltschrankes 10 nimmt die elektronischen Bauteile 30 auf. Auch bei dieser Ausführungsform kann die Membranwand 20 senkrecht, waagerecht oder diagonal verlaufend angeordnet sein.

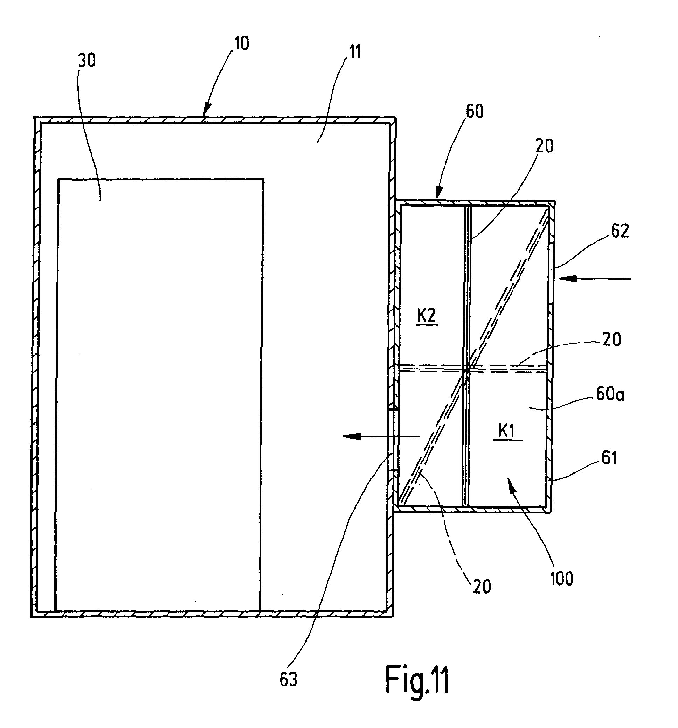

Nach Fig. 11 ist als Einrichtung 100 an mindestens einer der Schaltschrankwände mindestens ein Wandmodul 60 vorgesehen, das aus einem Gehäuse 61 besteht, in dessen Innenraum 60a eine den Innenraum in zwei Kammern K1, K2 unterteilende Membranwand 20 angeordnet ist, wobei die Kammer K1 über eine Öffnung 62 in der Wand des Gehäuses 61 mit der Umgebungsluft und die Kammer K2 über eine Öffnung 63 in der Wand des Gehäuses 61 und in der Wand des Schaltschrankes 10 mit dem Innenraum 11 des Schaltschrankes 10 in Verbindung steht. Der Innenraum 11 des Schaltschrankes 10 nimmt die elektronischen Bauteile 30 auf. Die Membranwand 20 kann waagerecht, senkrecht oder diagonal angeordnet sein.

Nach Fig. 11 ist das Wandmodul 60 mit der Einreichung 100 an der Außenwandfläche einer Schaltschrankwand angeordnet. Es besteht jedoch auch die Möglichkeit, das Wandmodul an der Innenwandfläche einer Schaltschrankwand anzuordnen, wobei gewährleistet sein muss, dass die eine Kammer K1 des Innenraumes 60a des Gehäuses 61 des Wandmoduls 60 mit der Umgebungsluft und die andere Kammer K2 mit dem Innenraum 11 des Schaltschrankes 10 in Verbindung steht.

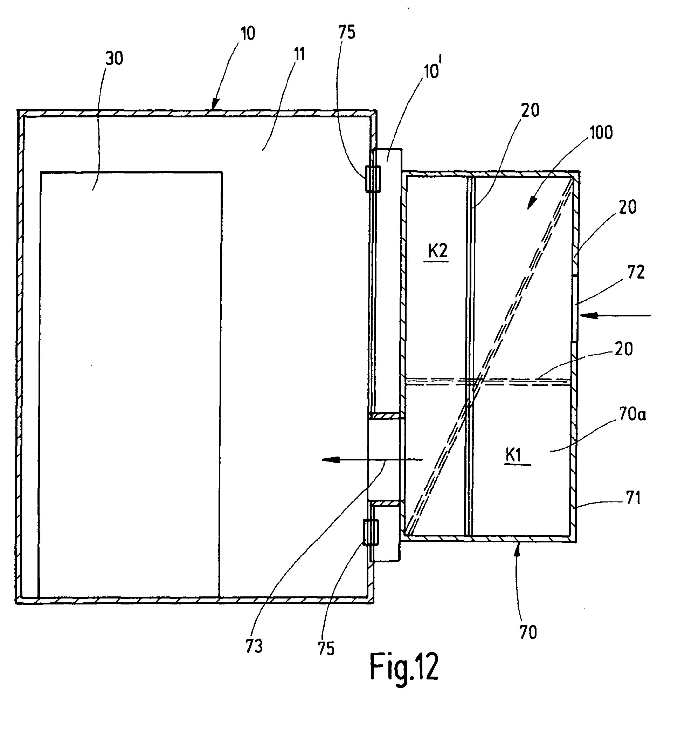

Fig. 12 zeigt eine Ausführungsform eines Schaltschrankes 10, der als Einrichtung 100 ein Wandmodul 70 aufweist, das an der Wand der Schaltschranktür 10' des Schaltschrankes angeordnet ist. Das Wandmodul 70 besteht aus einem Gehäuse 71, in dessen Innenraum 70a eine den Innenraum in zwei Kammern K1, K2 unterteilende Membranwand 20 angeordnet ist. Die Kammer K1 steht über eine Öffnung 72 in der Wand des Gehäuses 71 mit der Umgebungsluft und die Kammer K2 über eine Öffnung 73 in der Wand des Gehäuses 71 und der Wand der Schaltschranktür 10' im geschlossenen Zustand der Tür 10' mit dem Innenraum 11 des Schaltschrankes in Verbindung, der die elektronischen Bauteile 30 aufnimmt. Die Schaltschranktür 10' ist vermittels Scharniere 75, 75a mit der Schaltschrankwand verbunden. Die Membranwand 20 kann waagerecht, senkrecht oder diagonal angeordnet sein.

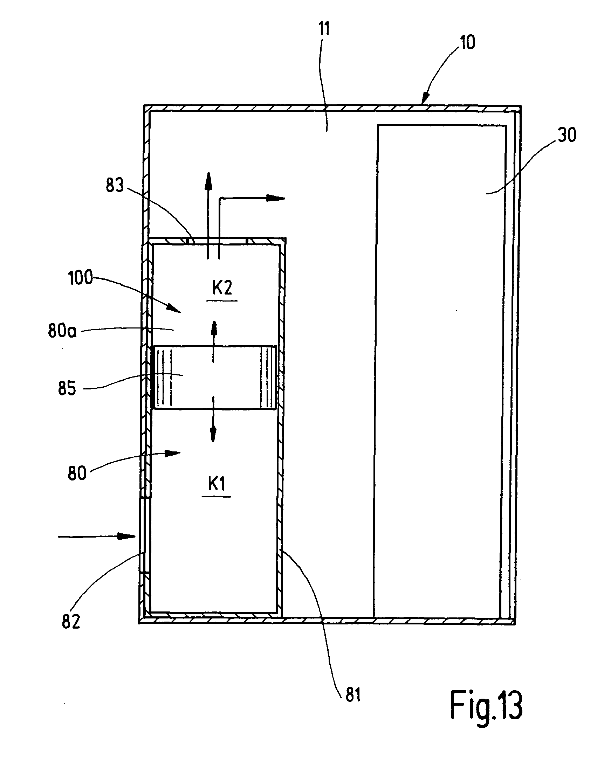

Die Ausführungsform nach Fig. 13 sieht als Einrichtung 100 ein in dem Innenraum 11 des Schaltschrankes 10 angeordnetes Kolbenelement 80 vor, das aus einem bevorzugterweise zylindrischen Gehäuse 81 besteht, in dessen Innenraum 80a ein Kolben 85 in Gehäuselängsrichtung verschieblich angeordnet ist. Der Kolben 85 unterteilt den Innenraum 80a des Gehäuses 81 in zwei Kammern K1 und K2. Die Kammer K1 steht über eine Öffnung 82 in der Wand des Gehäuses 81 mit der Umgebungsluft und die Kammer K2 mit dem Innenraum 11 des Schaltschrankes 10 über eine obere Öffnung 83 in Verbindung.

Als Einrichtung 100 kann jede Ausgestaltung eingesetzt werden, so z. B. faltenbalgartige konstruktive Ausgestaltung, federbeaufschlagte Platten o. dgl., die bei Druckbeaufschlagung im Innenraum des Schaltschrankes ein Druck aufbaut, der den von außen auf den Schaltschrank einwirkenden Druck kompensiert, so dass die Schaltschrankwände bei Außendruckbeaufschlagung keine Veränderungen erfahren. Im Augenblick der Druckbeaufschlagung von außen auf die Schaltschrankwände wird im Innenraum des Schaltschrankes ein Gegendruck aufgebaut der gleich dem Außendruck ist, jedoch auch über dem Außendruck liegen kann.

## Patentansprüche

1. Druck- und/oder Sogkräften ausgesetzter Schaltschrank (10) mit oder ohne Schaltschranktür (10'), insbesondere zur Aufstellung in Tunnelbereichen und/oder in Verbindungsstollen von Tunnelröhren, insbesondere für Schienenfahrzeuge,
**dadurch gekennzeichnet,**
**dass** zur Vermeidung einer Verformung des Schaltschrankes (10) und seiner Wände und zur Erhöhung seiner Standfestigkeit bei Einwirkung von Druck- und/oder Saugkräften der Schaltschrank (10) mit Einrichtungen (100) für einen vom Außendruck bzw. von Sogkräften abhängigen Druckausgleich im Innenraum (11) des Schaltschrankes versehen ist.

2. Schaltschrank nach Anspruch 1,
**dadurch gekennzeichnet,**
**dass** als Einrichtung (100) für einen vom Außendruck bzw. von Sogkräften abhängigen Druckausgleich im Innenraum (11) des Schaltschrankes mindestens eine im Innenraum (11) des Schaltschrankes (10) angeordnete, den Innenraum (11) in mindestens zwei Kammern (K1, K2) unterteilende Membranwand (20) vorgesehen ist, wobei eine der beiden Kammern (K1, K2) mit der Umgebungsluft in Verbindung steht und die jeweils andere Kammer gegebenenfalls die elektronischen Bauteile (30) aufnimmt, wobei die Membranwand (30) Druck- und Saugkräfte aufnimmt zur Schaffung gleicher Druckverhältnisse auf den Innenseiten und Außenseiten des Schaltschrankes (10) durch einen Druckaufbau im Innenraum (11) des Schaltschrankes (10) zur Schaffung eines Druckausgleichs.

3. Schaltschrank nach einem der Ansprüche 1 oder 2,
**dadurch gekennzeichnet,**
**dass** als Einrichtung (100) für einen vom Außendruck bzw. von Sogkräften abhängigen Druckausgleich im Innenraum (11) des Schaltschrankes mindestens eine Wand (10a; 10b; 10c; 10d) des Schaltschrankes (10) oder Teilbereiche der Schaltschrankwand bzw. -wände als Membran (20) ausgebildet ist.

4. Schaltschrank nach Anspruch 1,
**dadurch gekennzeichnet,**
**dass** als Einrichtung (100) für einen vom Außendruck bzw. von Sogkräften abhängigen Druckausgleich im Innenraum (11) des Schaltschrankes der Innenraum (11) des Schaltschrankes (10) in mindestens zwei durch eine Trennwand (15) getrennte Kammern (K1, K2) unterteilt ist, von denen die erste Kammer (K1) die elektronischen Bauteile (30) aufnimmt und der Innenraum (11a) der zweiten Kammer (K2) über eine Durchbrechung (12) in der die zweite Kammer (K2) begrenzenden Seitenwand (10a) mit der Außenluft verbunden ist, wobei die Trennwand (15) als Membran (20) ausgebildet ist.

5. Schaltschrank nach Anspruch 1,
**dadurch gekennzeichnet,**
**dass** als Einrichtung (100) für einen vom Außendruck bzw. von Sogkräften abhängigen Druckausgleich im Innenraum (11) des Schaltschrankes der Innenraum (11) des Schaltschrankes (10) in drei durch zwei Trennwände (15, 115) getrennte Kammern (K1, K2, K3) unterteilt ist, von denen die mittlere Kammer (K1) die elektronischen Bauteile (30) aufnimmt und von denen die jeweils außenliegende Kammer (K2 oder K3) oder beide außenliegenden Kammern (K2, K3) über eine Durchbrechung (12) oder zwei Durchbrechungen (12, 112) in der die Kammern (K2, K3) begrenzenden Außen-Seitenwand (10a, 10'a) mit der Außenluft verbunden ist, wobei die Trennwände (15, 115) als Membran (20) ausgebildet sind.

6. Schaltschrank nach Anspruch 1,
**dadurch gekennzeichnet,**
**dass** als Einrichtung (100) für einen vom Außendruck bzw. von Sogkräften abhängigen Druckausgleich im Innenraum (11) des Schaltschrankes der Innenraum (11) des Schaltschrankes (10) in durch eine feststehende, unelastische Trennwand (215) getrennte Kammern (K1, K2) unterteilt ist, von denen die Kammer (K1) die elektronischen Bauteile (30) aufnimmt, und der Innenraum (11) der bauteilfreien Kammer (K2) über eine in der die Kammer (K2) begrenzenden Schaltschrankwand (10a) ausgebildeten Durchbrechung (212) mit der Außenluft verbunden ist, wobei in der bauteilfreien Kammer (K2) ein vollelastischer Behälter, Schlauch oder Sack (50) angeordnet ist, der mit einem gasförmigen Medium, wie Luft, gefüllt ist und der in allen Richtungen Druckwellen kompensierbar ist.

7. Schaltschrank nach einem der Ansprüche 1 bis 6,
**dadurch gekennzeichnet,**
**dass** die die Kammern (K2, K3) in dem Innenraum (11) des Schaltschrankes (10) mit der Umgebungsluft verbindenden Durchbrechungen (112, 212) in der Schaltschrankwand mittels Gitter verschlossen sind.

8. Schaltschrank nach Anspruch 1,
**dadurch gekennzeichnet,**
**dass** als Einrichtung (100) für einen vom Außendruck bzw. von Sogkräften abhängigen Druckausgleich im Innenraum (11) des Schaltschrankes der Schaltschrank (10) mit mindestens einem in den Innenraum (11) des Schaltschrankes einschiebbaren, gehäuseartigen Einschubmodul (40) versehen ist, dessen Innenraum (40a) mindestens eine den Innenraum (40a) in zwei Kammern (K1, K2) unterteilende Membranwand (20) aufweist, wobei die eine Kammer (K1) mit der Umgebungsluft und die andere Kammer (K2) mit dem Innenraum (11) des Schaltschrankes (10) in Verbindung steht.

9. Schaltschrank nach Anspruch 1,
**dadurch gekennzeichnet,**
**dass** als Einrichtung (100) für einen vom Außendruck bzw. von Sogkräften abhängigen Druckausgleich im Innenraum (11) des Schaltschrankes der Schaltschrank (10) mit einem gehäuseartigen Dachmodul (50) versehen ist, das auf den Schaltschrank (10) aufgesetzt ist und dessen Innenraum (50a) mindestens eine den Innenraum (50a) in zwei Kammern (K1, K2) unterteilende Membranwand (20) aufweist, wobei die eine Kammer (K1) mit der Umgebungsluft und die andere Kammer (K2 ) mit dem Innenraum (11) des Schaltschrankes (10) in Verbindung steht.

10. Schaltschrank nach Anspruch 1,
**dadurch gekennzeichnet,**
**dass** als Einrichtung (100) für einen vom Außendruck bzw. von Sogkräften abhängigen Druckausgleich im Innenraum (11) des Schaltschrankes der Schaltschrank (10) mit mindestens einem gehäuseartigen Wandmodul (60) versehen ist, das an der Innenwandfläche oder Außenwandfläche einer Wand des Schaltschrankes (10) befestigt ist und dessen Innenraum (60a) mindestens eine den Innenraum (60a) in zwei Kammern (K1, K2) unterteilende Membranwand (20) aufweist, wobei die eine Kammer (K1) mit der Umgebungsluft und die andere Kammer (K2) mit dem Innenraum (11) des Schaltschrankes (10) in Verbindung steht.

11. Schaltschrank nach Anspruch 1,
**dadurch gekennzeichnet,**
**dass** als Einrichtung (100) für einen vom Außendruck bzw. von Sogkräften abhängigen Druckausgleich im Innenraum (11) des Schaltschrankes der Schaltschrank (10) mit mindestens einem gehäuseartigen Wandmodul (70) versehen ist, das an der Tür (10') des Schaltschrankes (10) befestigt ist und dessen Innenraum (70a) mindestens eine den Innenraum (70a) in zwei Kammern (K1, K2) unterteilende Membranwand (20) aufweist, wobei die eine Kammer (K1) mit der Umgebungsluft und die andere Kammer (K2) mit dem Innenraum (11) des Schaltschrankes (10) bei geschlossener Schaltschranktür (10') in Verbindung steht.

12. Schaltschrank nach einem der Ansprüche 8 bis 11,
**dadurch gekennzeichnet,**
**dass** die Membranwand (20) horizontal angeordnet den Innenraum des Einschubmoduls (40) oder des Dachmoduls (50) oder des Wandmoduls (60; 70) in zwei nebeneinander oder übereinander liegende Kammern (K1, K2) unterteilt.

13. Schaltschrank nach einem der Ansprüche 8 bis 11,
**dadurch gekennzeichnet,**
**dass** die Membranwand (20) senkrecht angeordnet, den Innenraum des Einschubmoduls (40) oder des Dachmoduls (50) oder des Wandmoduls (60; 70) in zwei nebeneinander oder übereinanderliegende Kammern (K1, K2) unterteilt.

14. Schaltschrank nach einem der Ansprüche 8 bis 11,
**dadurch gekennzeichnet,**
**dass** die Membranwand (20) diagonal oder schräg verlaufend angeordnet, den Innenraum des Einschubmoduls (40) oder des Dachmoduls (50) oder des Wandmoduls (60; 70) in zwei nebeneinander oder übereinander liegende Kammern (K1, K2) unterteilt.

15. Schaltschrank nach einem der Ansprüche 1 bis 14,
**dadurch gekennzeichnet,**
**dass** die Membranwand (20) aus einem gummielastischen oder einem anderen geeigneten Material besteht.

16. Schaltschrank nach Anspruch 1,
**dadurch gekennzeichnet,**
**dass** die Einrichtung (100) für einen vom Außendruck bzw. von Sogkräften abhängigen Druckausgleich im Innenraum (11) des Schaltschrankes aus einem in dem Innenraum (11) des Schaltschrankes (10) angeordneten Kolbenelement (80) oder Faltenbalgelement besteht, wobei das Kolbenelement (80) aus einem Gehäuse (81) mit einem in diesem geführten das Gehäuse (81) in zwei Kammern (K1, K2) unterteilenden Kolben (85) besteht, wobei die eine Kammer (K1) mit der Umgebungsluft und die andere Kammer (K2) mit dem Innenraum (11) des Schaltschrankes (10) in Verbindung steht.
